# EUROPÄISCHE PATENTSCHRIFT

(11) **EP 1 972 107 B1**
(45) Veröffentlichungstag und Bekanntmachung des Hinweises auf die Patenterteilung: **26.05.2010**
(21) Anmeldenummer: 06722727.2
(22) Anmeldetag: 29.03.2006
(51) Int. Cl.: H04L 12/56

(54) **SCHUTZ- ODER LEITTECHNIKGERÄT**
PROTECTION OR CONTROL-SYSTEM APPLIANCE
APPAREIL DE PROTECTION OU DE COMMANDE

(30) Priorität: 12.01.2006 WO PCT/DE2006/000052; 01.02.2006 WO PCT/DE2006/000179
(43) Veröffentlichungstag der Anmeldung: 24.09.2008
(73) Patentinhaber: SIEMENS AKTIENGESELLSCHAFT, 80333 München (DE)
(72) Erfinder: HOGA, Clemens, 90403 Nürnberg (DE); LANG, Gerhard, 14557 Wilhelmshorst (DE); NEUMANN, Götz, 13627 Berlin (DE)
(86) Internationale Anmeldenummer: PCT/DE2006/000576
(87) Internationale Veröffentlichungsnummer: WO 2007/079703

(56) Entgegenhaltungen:
- WO-A-2004/030284
- US-A1- 2004 252 682
- US-A1- 2005 169 262
- US-A1- 2005 254 490

## Beschreibung

Die Erfindung bezieht sich auf ein Schutz- oder Leittechnikgerät für eine Energieversorgungsanlage, wobei das Schutz- oder Leittechnikgerät (10) eine Mehrzahl an geräteinternen Gerätemodulen umfasst, die zum Zwecke eines Datenaustausches miteinander in Verbindung stehen.

Geräte auf dem Gebiet der digitalen Schaltanlagenleit- und Schutztechnik werden vorzugsweise mit einer modularen Hardwareplattform ausgestattet, damit sie hinsichtlich des Ausbau- und Funktionsgrades einfach und kostenoptimiert an die jeweiligen Anforderungen angepasst werden können. Solche Anforderungen bestehen beispielsweise in der Art und der Leistungsfähigkeit von Kommunikationsschnittstellen, der Anzahl binärer Ein- und Ausgänge sowie der Funktionsdichte und Leistungsfähigkeit des Gerätes. Die Plattformeigenschaften der Schutz- und Leittechnikgeräte werden derzeit auf Hardwareseite durch einen internen Gerätebus bereitgestellt. In diesem Zusammenhang bekannt sind beispielsweise die Schutzgeräte der Firma SIEMENS AG, die unter dem Produktnamen SIPROTEC vertrieben werden und mit einem parallelen Adress-, Daten- und Steuerbus ausgestattet ist.

Der Erfindung liegt die Aufgabe zugrunde, ein Schutz- bzw. Leittechnikgerät anzugeben, das einen modularen Aufbau aufweist und es ermöglicht, bei Bedarf einfach und kostengünstig Gerätemodule auszutauschen oder zusätzliche Gerätemodule in das Gerät einzusetzen; dennoch soll ein sehr hoher Grad an Datensicherheit innerhalb des Schutz- bzw. Leittechnikgerätes gewährleistet werden.

Diese Aufgabe wird erfindungsgemäß dadurch gelöst, dass das Schutz- oder Leittechnikgerät (10) ferner eine Mehrzahl an Ethernet-Schaltern (80) und einen geräteinternen Ethernet-Ring (70) umfasst, wobei die geräteinternen Gerätemodule jeweils über einen Ethernet-Schalter - nachfolgend auch Ethernet-Switch genannt - mit dem geräteinternen Ethernet-Ring in Verbindung stehen und dazu ausgebildet sind, über diesen ihre Daten auszutauschen.

Ethernet-Switches als solche sind bereits aus dem Stand der Technik bekannt. Beispielhaft wird auf die US 2005/0254490 A1 hingewiesen, die einen Ethernet-Switch offenbart, der Netzwerk-Überwachungsgeräten, wie z.B. einem sogenannten "Intrusion Detection System" (= Eindringlingserkennungssystem), Zugriff auf große Teile des Netzwerks erlaubt.

Ein wesentlicher Vorteil des erfindungsgemäßen Schutz- bzw. Leittechnikgeräts ist darin zu sehen, dass dieses bezüglich der geräteinternen Modulverbindung auf die bekannte Ethernet-Technik zurückgreift; dies ermöglicht es, allgemein zugängliche und ausgereifte Treiberkomponenten einzusetzen.

Ein weiterer wesentlicher Vorteil des erfindungsgemäßen Schutz- bzw. Leittechnikgeräts ist darin zu sehen, dass dieses aufgrund des vorhandenen geräteinternen Ethernet-Rings eine sehr hohe Datensicherheit gewährleistet, denn aufgrund der Ringstruktur ist eine Redundanz vorhanden: Wird nämlich der Ethernetring an einer Stelle absichtlich oder unabsichtlich unterbrochen, so bleibt die Datenverbindung zwischen den an den Ring angeschlossenen Gerätemodulen dennoch erhalten, da der Ring eine Datenübertragung um die Unterbrechungsstelle herum ermöglicht.

Besonders kostengünstig und damit vorteilhaft lässt sich ein Schutz- oder Leittechnikgerät mit einem Ethernet-Ring ausstatten, wenn als Ethernet-Schalter 3-Port-Schalter eingesetzt werden, wie sie in der deutschen Offenlegungsschrift DE 102 60 806 A1 beschrieben sind. Bevorzugt werden die 3-Port-Schalter durch monolithisch integrierte Komponenten, insbesondere in FPGA oder ASIC-Bauweise, gebildet.

Im Hinblick darauf, dass in Schutz- und Leittechnikgeräten zeitkritische Daten verarbeitet werden, wird es als vorteilhaft angesehen, wenn der Ethernet-Ring echtzeitfähig ausgestaltet ist. Der Ethernet-Ring kann beispielsweise gemäß der bekannten Profinet-Norm "i-RTE" arbeiten.

Mit Blick auf eine maximale Datenübertragungsgeschwindigkeit wird es als vorteilhaft angesehen, wenn die Ethernet-Schalter im sogenannten "Cut-Through"-Verfahren arbeiten. Ein solches Verfahren wird in der Fachliteratur auch als "Cut-Through-Routing" bezeichnet. Unter einem Cut-Through-Verfahren ist ein Verfahren zu verstehen, bei dem an einem Ethernet-Switch ankommende Daten ohne Zwischenspeicherung weitergeleitet werden, wenn diese nicht für das an den jeweiligen Switch angeschlossene Gerätemodul bestimmt sind.

Um einen besonders einfachen mechanischen Aufbau des Schutz- bzw. Leittechnikgeräts zu erreichen, wird es als vorteilhaft angesehen, wenn die Gerätemodule an einer sogenannten Hutschiene, wie sie beispielsweise von Sicherungskästen und dergleichen bekannt ist, befestigt werden; eine solche Hutschiene ermöglicht es, auf sehr einfache Weise nachträglich Gerätemodule in den Ethernet-Ring zu integrieren, indem die auf der Hutschiene befindlichen Gerätemodule an der gewünschten Einkoppelstelle auseinandergeschoben werden oder indem das zusätzliche Gerätemodul am äußeren Rand der Hutschiene aufgebracht und mit den übrigen Gerätemodulen an den Ethernet-Ring angeschlossen wird.

Vorzugsweise werden die Ethernet-Schalter durch einen FPGA- oder ASIC-Baustein gebildet; derartige Bausteine ermöglichen geringe Herstellungskosten.

Im Hinblick auf besonders geringe Herstellungskosten wird es als vorteilhaft angesehen, wenn zwei oder mehr Ethernet-Schalter in ein und demselben monolithisch integrierten Baustein, beispielsweise einem FPGA- oder ASIC-Baustein, integriert werden und einen vollständig integrierten Ethernet-Ring bilden. In einem solchen Fall wird eine Datenübertragung in sehr einfacher Weise dadurch ermöglicht, dass die geräteinternen Module von außen an den monolithisch integrierten Baustein angeschlossen werden; die ringbezogene Datenübertragung erfolgt dann innerhalb des monolithisch integrierten Bausteins.

Die Erfindung wird nachfolgend anhand von Ausführungsbeispielen näher erläutert. Dabei zeigen beispielhaft
- Figur 1: ein Ausführungsbeispiel für ein Schutz- oder Leit- technikgerät mit einem integrierten Switch-Ether- net-Ring,
- Figur 2: ein Ausführungsbeispiel für den mechanischen Aufbau des Geräts gemäß Figur 1 und
- Figur 3: ein Ausführungsbeispiel für einen für das Gerät ge- mäß Figur 1 geeigneten Baustein, in dem ein kom- pletter Ethernet-Ring monolithisch integriert ist.

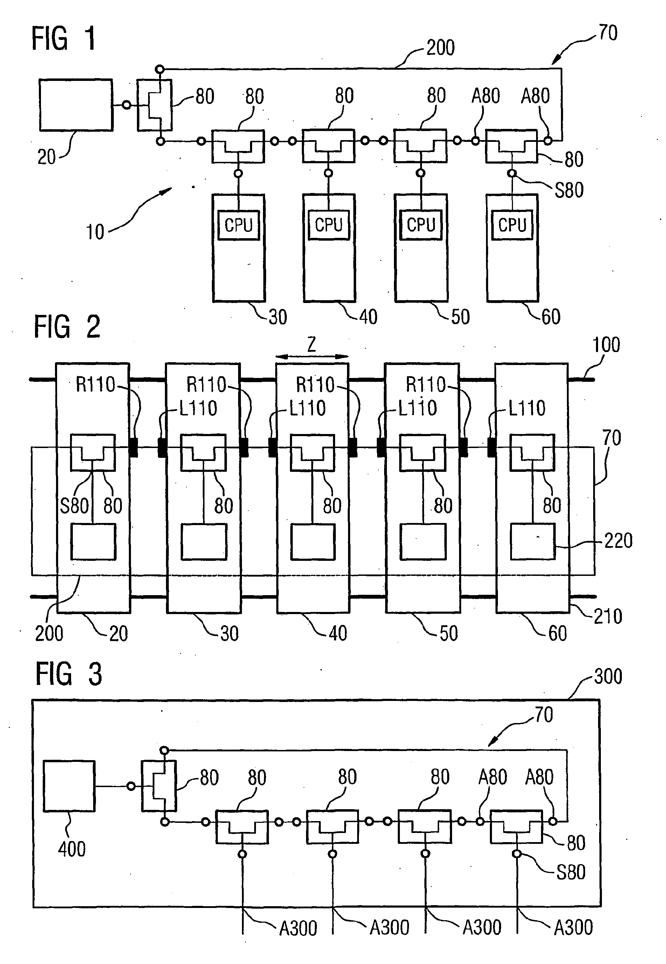

In der Figur 1 erkennt man ein Schutz- bzw. Leittechnikgerät' 10 - nachfolgend kurz Schutzgerät 10 genannt -, das mit einer Haupt-CPU 20 sowie weiteren geräteinternen Gerätemodulen, und zwar einem Binäreingabemodul 30, einem Kommunikationsmodul 40, einem Messwertmodul 50 sowie einem Befehlsmodul 60 ausgestattet ist.

Die Haupt-CPU 20 sowie die vier geräteinternen Gerätemodule sind über einen echtzeitfähigen Switch-Ethernet-Ring 70 miteinander verbunden. Der Anschluss der Haupt-CPU 20 sowie der vier geräteinternen Gerätemodule 30, 40, 50 und 60 an den Ethernet-Ring 70 erfolgt jeweils über einen Ethernet-Schalter bzw. Ethernet-Switch 80. Wie sich der Figur 1 entnehmen lässt, ist jeder Ethernet-Switch 80 jeweils durch einen 3-Port-Schalter gebildet. Der interne Aufbau der 3-Port-Schalter kann beispielsweise dem Aufbau entsprechen, wie er in der Offenlegungsschrift DE 102 60 806 A1 beschrieben ist.

Die 3-Port-Schalter 80 weisen - wie der Name andeutet - jeweils drei Anschlüsse auf. Zwei der Anschlüsse sind mit dem Bezugszeichen A80 gekennzeichnet und dienen dazu, die Ringstruktur des Ethernet-Ringes zu realisieren. Der dritte Anschluss S80 ermöglicht es, ein geräteinternes Gerätemodul oder auch die Haupt-CPU 20 an den Ethernet-Ring 70 anzuschließen; der dritte Anschluss S80 kann beispielsweise ein Interface nach dem MII-Standard bilden.

Die Funktionsweise des Ethernet-Rings 70 gemäß Figur 1 entspricht dem üblichen Ethernet-Standard, so dass diesbezüglich auf die einschlägige Fachliteratur verwiesen werden kann. Der Ethernet-Ring 70 arbeitet beispielsweise mit einer Datenrate von einem Gigabit/sec sowie besonders bevorzugt nach der Profinet-Norm i-RTE.

Um eine hohe Datengeschwindigkeit zu erreichen, sind die 3-Port-Schalter 80 jeweils derart ausgestaltet, dass sie nach dem sogenannten Cut-Through-Verfahren arbeiten. Dies bedeutet, dass Daten; die über den Ring übertragen werden, ohne eine Zwischenspeicherung unmittelbar weitergeleitet werden, wenn diese nicht für das jeweils eigene Gerätemodul bestimmt sind; eine solche unmittelbare Weiterleitung ohne Zwischenspeicherung erfordert eine zügige Bearbeitung der eingehenden Daten, da die 3-Port-Schalter in Echtzeit überprüfen müssen, welche der eingehenden Daten für das eigene geräteinterne Gerätemodul relevant sind und welche nicht.

In der Figur 2 ist ein Ausführungsbeispiel für den mechanischen Aufbau des Schutzgeräts 10 gemäß Figur 1 gezeigt. Man erkennt eine Hutschiene 100, auf der die Gerätemodule 30, 40, 50, und 60 sowie die Haupt-CPU 20 aufgesteckt sind. An jedem der Gerätemodule sowie der Haupt-CPU 20 sind seitlich jeweils zwei Netzwerkanschlüsse L110 und R110 angebracht. Der in der Figur 2 jeweils linke Netzwerkanschluss ist mit dem Bezugszeichen L110 und der in der Figur 2 rechte Netzwerkanschluss jeweils mit dem Bezugszeichen R110 bezeichnet.

Nachdem die Gerätemodule auf der Hutschiene 100 aufgesteckt worden sind, werden diese entlang der Längsrichtung Z der Hutschiene 100 so zusammengeschoben, dass die Netzwerkanschlüsse L110/R110 untereinander in Kontakt - optisch oder elektrisch - kommen und der Ethernet-Ring 70 gemäß Figur 1 geschlossen wird. Konkret wird beispielsweise der rechte Netzwerkanschluss R110 des Binäreingabemoduls 30 mit dem linken Netzwerkanschluss L110 des Kommunikationsmoduls 40 zusammengesteckt. In entsprechender Weise erfolgt ein Zusammenstecken aller Gerätemodule 30 bis 60 auf der Hutschiene 100. Auch die Haupt-CPU 20 kann in entsprechender Weise auf die Hutschiene 100 aufgesteckt und mit den geräteinternen Modulen 30 und 60 in Verbindung gebracht werden.

Die den Ethernet-Ring 70 schließende Ringleitung, die in der Figur 1 mit dem Bezugszeichen 200 gekennzeichnet ist, kann beispielsweise in der Hutschiene 100 integriert sein. Dies ist schematisch durch eine gestrichelte Linie mit dem Bezugszeichen 200 in der Figur 2 angedeutet.

Wie in der Figur 2 außerdem gezeigt ist, können die geräteinternen Gerätemodule jeweils durch eine Leiterplatte 210 gebildet sein, auf der eine oder mehrere elektronische Komponenten 220 wie beispielsweise Mikroprozessoranordnungen oder dergleichen vorhanden sind.

In der Figur 3 ist ein Ausführungsbeispiel für ein integriertes elektronisches Bauelement 300 gezeigt, bei dem es sich beispielsweise um einen FPGA- oder ASIC-Baustein handeln kann. In dem Bauelement 300 ist ein Ethernet-Ring 70 monolithisch integriert. Auch die an den Ethernet-Ring 70 angeschlossenen Ethernet-Schalter (Ethernet Switch) 80, bei denen es sich beispielsweise um 3-Port-Schalter handelt, sind in dem Bauelement 300 monolithisch integriert.

Nach außen stellt das Bauelement 300 eine Vielzahl an Anschlüssen A300 zur Verfügung, die durch die Datenanschlüsse S80 der Ethernet-Schalter 80 gebildet sind. An diese Anschlüsse A300 kann jeweils ein Gerätemodul angeschlossen werden, um eine Verbindung zu dem monolithisch integrierten Ethernet-Ring 70 herzustellen. Das Bauelement 300 ermöglicht somit einen räumlich sternförmigen Anschluss mehrerer Gerätemodule an den Baustein 300, wobei die angeschlossenen Gerätemodule über den integrierten Ethernet-Ring 70 miteinander elektrisch in einer "ringförmigen" Datenverbindung stehen.

Der in der Figur 3 dargestellte monolithisch integrierte Baustein 300 kann beispielsweise für das Schutz- bzw. Leittechnikgerät 10 gemäß Figur 1 eingesetzt werden. In diesem Fall werden die Haupt-CPU 20 sowie die geräteinternen Gerätemodule 30 bis 60 jeweils an einen der Anschlüsse A300 des Bausteins 300 angeschlossen.

In dem Baustein 300 kann beispielsweise zusätzlich auch ein Mikroprozessor bzw. eine CPU 400 integriert sein, wie dies die Figur 3 beispielhaft zeigt. Die CPU 400 kann beispielsweise die Haupt-CPU 20 gemäß der Figur 1 bilden.

## Patentansprüche

1. Schutz- oder Leittechnikgerät (10) für eine Energieversorgungsanlage, wobei das Schutz- oder Leittechnikgerät (10) eine Mehrzahl an geräteinternen Gerätemodulen (30, 40, 50, 60) umfasst, die zum Zwecke eines Datenaustausches miteinander in Verbindung stehen,
**dadurch gekennzeichnet, dass** das Schutz- oder Leittechnikgerät (10) ferner eine Mehrzahl an Ethernet-Schaltern (80) und einen geräteinternen Ethernet-Ring (70) umfasst, wobei
die geräteinternen Gerätemodule (30, 40, 50, 60) jeweils über einen Ethernet-Schalter (80) mit dem geräteinternen Ethernet-Ring (70) in Verbindung stehen und dazu ausgebildet sind, über diesen ihre Daten auszutauschen.

2. Schutz- oder Leittechnikgerät nach Anspruch 1,
**dadurch gekennzeichnet, dass**
zumindest einer der Ethernet-Schalter, vorzugsweise alle Ethernet-Schalter, durch einen 3-Port-Schalter (80) gebildet sind.

3. Schutz- oder Leittechnikgerät nach Anspruch 1 oder 2,
**dadurch gekennzeichnet, dass**
der Ethernet-Ring (70) echtzeitfähig ist.

4. Schutz- oder Leittechnikgerät nach Anspruch 3,
**dadurch gekennzeichnet, dass**
der Ethernet-Ring (70) gemäß Profinet-Norm i-RTE arbeitet.

5. Schutz- oder Leittechnikgerät nach einem der voranstehenden Ansprüche,
**dadurch gekennzeichnet, dass**
die Ethernet-Schalter (80) im Cut-Through-Verfahren arbeiten.

6. Schutz- oder Leittechnikgerät nach einem der voranstehenden Ansprüche,
**dadurch gekennzeichnet, dass**
die Gerätemodule an einer Hutschiene (100) befestigt sind.

7. Schutz- oder Leittechnikgerät nach einem der voranstehenden Ansprüche,
**dadurch gekennzeichnet, dass**
zumindest einer der Ethernet-Schalter durch einen monolithisch integrierten Baustein, insbesondere einen FPGA- oder ASIC-Baustein, gebildet ist.

8. Schutz- oder Leittechnikgerät nach Anspruch 7,
**dadurch gekennzeichnet, dass**
zwei oder mehr der Ethernet-Schalter (80) in ein und demselben monolithisch integrierten Baustein (300) integriert sind und einen integrierten Ethernet-Ring (70), zumindest einen Teil eines solchen Rings, bilden.

## Claims

1. Protection or control-system appliance (10) for a power supply installation, the protection or control-system appliance (10) comprising a plurality of appliance-internal appliance modules (30, 40, 50, 60) which are connected to one another for the purpose of interchanging data,
**characterized in that**
the protection or control-system appliance (10) furthermore comprises a plurality of Ethernet switches (80) and an appliance-internal Ethernet ring (70),
the appliance-internal appliance modules (30, 40, 50, 60) each being connected to the appliance-internal Ethernet ring (70) by means of an Ethernet switch (80) and being designed to interchange their data via said ring.

2. Protection or control-system appliance according to Claim 1,
**characterized in that**
at least one of the Ethernet switches, preferably all of the Ethernet switches, is/are formed by a 3-port switch (80).

3. Protection or control-system appliance according to Claim 1 or 2,
**characterized in that**
the Ethernet ring (70) has real-time capability.

4. Protection or control-system appliance according to Claim 3,
**characterized in that**
the Ethernet ring (70) operates according to the i-RTE Profinet standard.

5. Protection or control-system appliance according to one of the preceding claims,
**characterized in that**
the Ethernet switches (80) operate using the cut-through method.

6. Protection or control-system appliance according to one of the preceding claims,
**characterized in that**
the appliance modules are fastened to a top-hat rail (100).

7. Protection or control-system appliance according to one of the preceding claims,
**characterized in that**
at least one of the Ethernet switches is formed by a monolithically integrated chip, in particular an FPGA or ASIC chip.

8. Protection or control-system appliance according to Claim 7,
**characterized in that**
two or more of the Ethernet switches (80) are integrated in the same monolithically integrated chip (300) and form an integrated Ethernet ring (70), or at least part of such a ring.

## Revendications

1. Appareil ( 10 ) de protection ou de commande pour une installation d'alimentation en énergie, l'appareil (10) de protection ou de commande comprenant une multiplicité de modules ( 30, 40, 50, 60 ) d'appareil internes à l'appareil, qui sont en liaison les uns avec les autres en vue d'un échange de données,
**caractérisé en ce que**
l'appareil ( 10 ) de protection ou de commande comprend, en outre, une multiplicité de commutateurs ( 80 ) éthernet et un anneau ( 70 ) éthernet interne à l'appareil, dans lequel les modules ( 30, 40, 50, 60 ) d'appareil internes à l'appareil sont en liaison respectivement avec l'anneau ( 70 ) éthernet interne à l'appareil par un commutateur ( 80 ) éthernet et constitués pour échanger leurs données par celui-ci.

2. Appareil de protection ou de commande suivant la revendication 1,
**caractérisé en ce que**
au moins l'un des commutateurs éthernet, de préférence tous les commutateurs éthernet, sont formés par un commutateur ( 80 ) à trois accès.

3. Appareil de protection ou de commande suivant la revendication 1 ou 2,
**caractérisé en ce que**
l'anneau ( 70 ) éthernet peut fonctionner en temps réel.

4. Appareil de protection ou de commande suivant la revendication 3,
**caractérisé en ce que**
l'anneau ( 70 ) éthernet fonctionne suivant la norme profinet i-RTE.

5. Appareil de protection ou de commande suivant l'une des revendications précédentes,
**caractérisé en ce que**
les commutateurs (80) éthernet fonctionnent suivant le procédé cut-through.

6. Appareil de protection ou de commande suivant l'une des revendications précédentes,
**caractérisé en ce que**
les modules d'appareil sont fixés à un profilé en chapeau.

7. Appareil de protection ou de commande suivant l'une des revendications précédentes,
**caractérisé en ce que**
au moins l'un des commutateurs éthernet est formé par un module intégré monolithiquement, notamment un module FPGA ou ASIC.

8. Appareil de protection ou de commande suivant la revendication 7,
**caractérisé en ce que**
deux ou plusieurs des commutateurs (80) éthernet sont intégrés dans un seul et même module (300) intégré monolithiquement et forment un anneau ( 70 ) éthernet intégré ou au moins une partie d'un anneau de ce genre.
